Europäisches Patentamt

European Patent Office

Office européen des brevets

(11) Publication number:

**0 298 046**
**A2**

# (12) EUROPEAN PATENT APPLICATION

(21) Application number: 88830234.6

(22) Date of filing: 23.05.88

(51) Int. Cl.⁴: **G 01 H 3/14**

(30) Priority: 03.07.87 IT 4008487

(43) Date of publication of application:
04.01.89 Bulletin 89/01

(84) Designated Contracting States:
AT BE CH DE ES FR GB GR LI NL SE

(71) Applicant: Firm DAVOLI ATHOS
Via F. Lombardi, 6/8
I-43100 Parma (IT)

(72) Inventor: Davoli, Athos
Via F. Lombardi, 6/8
I-43100 Parma (IT)

(74) Representative: Lanzoni, Luciano
c/o BUGNION S.p.A. Viale Trento Trieste, 25
I-41100 Modena (IT)

(54) Device for measuring, indicating and controlling sound pressure (or sound levels) in an evironment.

(57) The device for measuring, indicating and controlling ambient sound pressure levels comprises a probe (8) connected to a sound level meter (2), the output signal from which is proportional to sound pressure picked up by the probe; the signal from the meter is compared with a given threshold, and if found to be higher, causes a control signal to be generated that triggers the operation of indicator lights or alarms (6), and/or of a limiter (4) by which sound pressure in the environment is attenuated automatically.

The device is intended for use in surroundings such as discotheques, building sites or factory premises etc., where sound pressure levels attributable to noise generated within the environment can prove a source of annoyance, or even of harm, to persons occupying the area.

**Description**

The invention relates to a device for measuring, indicating and controlling sound pressure (or sound levels) in a given environment.

The object behind the device disclosed is that of providing efficient and constant control over sound pressure in an environment, be it building site, factory premises, discotheque, cinema etc... as well as producing an immediate indication the moment when sound pressure levels rise above preset thresholds and become a source of annoyance, or even of harm, to the persons occupying the environment.

One of the advantages provided by the device is that it becomes possible, in certain cases, to attenuate sound pressure automatically in the event that the level rises above the selected threshold.

The stated object and advantage, and others besides, are realized with a device as characterized in the appended claims, which comprises: a probe designed to sense sound pressure in the environment; an electronic sound level meter of conventional type, the input of which is in receipt of signals relayed by the probe, and the output of which produces a signal proportional to the sound pressure level registering through the input; a signal generator, serving to establish a threshold reference value proportional to the maximum permissible sound pressure level envisaged for the environment; a comparator circuit, serving to effect a comparison between the signal from the sound level meter and the signal from the generator, and to produce a control signal whenever the output signal from the sound level meter exceeds the threshold level for a given duration; and actuator means serving to convert the output signal from the comparator into an immediately perceptible sensation.

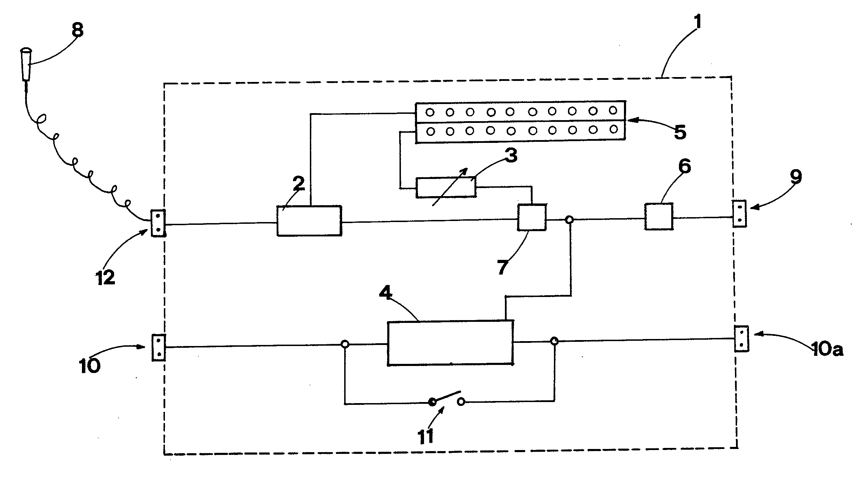

The invention will now be described in detail, by way of example, with the aid of the accompanying drawing, which is a block diagram of the device. The device disclosed comprises a sound probe, which may consist in an ordinary microphone 8 of any given type; the microphone 8 is generally positioned in that part of the environment where sound pressure is to be monitored, and where it is wished to detect any sound levels in excess of a given threshold.

The microphone converts sound pressure, that is, the sound it picks up, into an electrical signal; this is relayed to a conventional electronic sound level meter 2 capable of producing an output signal that will be proportional to the level of sound pressure registering at the microphone.

The device also comprises a generator 3 which serves to produce a threshold signal proportional to the maximum level of sound pressure envisaged for the environment, or rather, the area of the environment effectively monitored; in a preferred embodiment, the generator 3 will be adjustable to the end that the reference level, which remains constant during operation, can be altered to suit requirements. 7 denotes a circuit that compares the signal from the sound level meter 2 with the reference signal from the generator 3, and produces a control signal whenever the metered level rises above the reference level for a given duration. In short, the purpose of the comparator 7 is to react, by producing a control signal, whenever sound pressure registering in the monitored environment is higher than the threshold level envisaged -i.e. as reflected in the reference signal emitted by the generator 3.

The control signal is cascaded into actuator means, such as indicators, for example, by which it is converted into a sensation that will be immediately perceptible on the part of an operator whose job it is to monitor sound levels in the environment.

The actual indicator 6 might be a visual type, e.g. an electric lamp, or audible (siren, bleeper etc.). Operation of the indicators informs the operator immediately that permissible sound pressure levels have been exceeded in the monitored environment, and the operator can thus proceed to lower the offending pressure level, i.e. to reduce the sound level in the environment so that persons occupying the area will suffer no annoyance or harm.

The device incorporates level indicators 5, which in the drawing are embodied as sets of LEDs, although pointers or other conventional instruments could be used; these display both the signal from the meter 2 and the reference level from the generator 3. Thus, with visual comparison provided by the indicators 5, it becomes possible to keep a constant watch on the sound pressure level registering in the monitored environment, in relation to the selected threshold.

In the event that scund in the monitored environment is produced by equipment of the type designed to generate electrical signals which are preamplified, say by a mixer, and then amplified by one or more power units driving electroacoustic transducers (loudspeakers), as in the case of the discotheque, the actuator means may incorporate an automatic limiting system whereby the offending sound level will be lowered the moment that sound pressure rises above the threshold level. A conventional type of limiter 4 is illustrated, which would generally be connected in series with the transmission line through which the music signals are generated, for example immediately prior to the power amplifier input. When triggered into operation, the limiter has the effect of attenuating the signal passing through it, and thereby of attenuating the ultimate sound level, hence the sound pressure generated in the environment. Operation of the limiter 4 will be triggered by the control signal emitted from the comparator 7, in such a way that attenuation occurs only when sound pressure in the environment rises above the threshold level, i.e. the condition which initially produces the control signal, as described above. In this instance, the sensation perceived will be an immediate lowering of the sound intensity level in the environment.

11 denotes a switch, which is connected in parallel with and permits of by-passing the limiter 4. The option also exists of connecting a timer in parallel with the limiter and the by-pass loop, which permits of switching in the limiter at given times and for a given duration; such a timer is not illustrated, but will be conventional in design and operation.

The device is housed to advantage in a container, represented by the line denoted 1, which affords sockets 12, 9, 10 and 10a for the connection of the microphone 8, of an indicator located remotely from the device, of a preamplifier or mixer stage, and of final power amplifiers, respectively. The components listed do not form an integral part of the device, except for the microphone 8, and therefore are not illustrated; the method of connecting them will be obvious to a person skilled in the art, however.

In the event that the environment being monitored (or the particular part of the environment) happens to be located at some distance from the device, thus dictating a long microphone lead, the input signal can be boosted by a suitable amplifier.

Finally, it will be observed that the limiter 4 is designed to produce an attenuated output signal of identical configuration to the input signal, so that the musical quality and the dynamics of the sound orignally generated are not altered in any way; the limiter 4 in fact produces no modifying influence other than that of attenuating the strength of the signal overall.

19

## Claims

1) A device for measuring, indicating and controlling sound pressure (or sound levels) in an environment, characterized
in that it comprises:
-a probe (8) designed to sense sound pressure in the environment;
-an electronic sound level meter (2) of conventional type, the input of which is in receipt of signals relayed by the probe, the output of which produces a signal proportional to the sound pressure level registering through the input;
-a signal generator (3), serving to establish a threshold reference value proportional to a maximum permissible sound pressure level envisaged for the environment;
-a comparator circuit (7), serving to effect a comparison between the signal from the sound level meter and the signal from the generator, and to produce a control signal whenever the output signal from the sound level meter exceeds the threshold level for a given duration; and
-actuator means serving to convert the output signal from the comparator into an immediately perceptible sensation.

2) A device as in claim 1, wherein the actuator means comprise audible or visible indicator means (6).

3) A device as in claim 1, further comprising level indicators (5) of conventional type which display the output levels from the meter (2) and from the generator (3).

4) A device as in claim 1, wherein the actuator means comprise a limiter (4) of conventional type, wired to the input of at least one final amplifier stage driving electroacoustic transducers by which sound is generated in the monitored environment, the operation of which is triggered by the output signal from the comparator and serves to attenuate or otherwise control the electrical signal directed through it.

5) A device as in claim 4, further comprising a circuit (11) that permits of by-passing the limiter.

6) A device as in claim 5, further comprising a timer connected in parallel with the by-pass circuit and serving to switch in the limiter at given times or for given durations.

7) A device as in claim 1, wherein the level of the threshold reference signal selected by way of the generator is adjustable.